(19) Europäisches Patentamt
European Patent Office
Office européen des brevets

(11) **EP 4 632 823 A1**

(12) **EUROPEAN PATENT APPLICATION**
published in accordance with Art. 153(4) EPC

(43) Date of publication:
**15.10.2025 Bulletin 2025/42**

(21) Application number: **23899764.7**

(22) Date of filing: **21.11.2023**

(51) International Patent Classification (IPC):
***H01L 33/46*** (2010.01)    ***H10K 59/00*** (2023.01)

(52) Cooperative Patent Classification (CPC):
**H10H 20/831; H10H 20/832; H10H 20/841; H10K 59/00**

(86) International application number:
**PCT/CN2023/133010**

(87) International publication number:
**WO 2024/120185 (13.06.2024 Gazette 2024/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **06.12.2022 CN 202211562940**

(71) Applicant: **Suzhou Qiushui Semiconductor Technology Co., Ltd.
Suzhou, Jiangsu 215000 (CN)**

(72) Inventor: **JIANG, Zhenyu
Jiangsu 215000 (CN)**

(74) Representative: **Wörz, Volker Alfred
Wörz Patentanwälte PartG mbB
Gablenberger Hauptstraße 32
70186 Stuttgart (DE)**

(54) **LED DISPLAY DEVICE**

(57)    A LED display device includes a display substrate; the display substrate includes an epitaxial layer, a common electrode layer, a reflective layer, and reflective electrode patterns. The epitaxial layer includes a first semiconductor layer, an active layer, and a second semiconductor layer sequentially stacked. The second semiconductor layer has first recessed regions, and protruding tabs are formed by the first recessed regions. The common electrode layer fills the first recessed regions and contact side walls of protrusion structures. The reflective layer covers top walls of the protruding tabs and the common electrode layer. The reflective electrode patterns are arranged at intervals on the side of the first semiconductor layer away from the active layer. A reflectivity of the reflective layer is less than that of the reflective electrode patterns to form resonant cavities, allowing light to be output from one side of the reflective layer.

FIG. 1

## Description

### TECHNICAL FIELD

Embodiments of the present disclosure relate to the technical field of displaying, and more specifically, to a LED display device.

### BACKGROUND

The micro-LED technology is a technology of miniaturizing and matrixing traditional LEDs. For the micro-LED technology, traditional large-sized LED chips may be miniaturized firstly into micrometer-sized micro-LED chips. Subsequently, the micrometer-sized micro-LED chips are arranged into a matrix to form a high-density integrated LED array. In this way, each display pixel in a display screen applied with the micro-LED technology can be independently positioned and enabled to emit light, such that each of the micro-LED chips may be precisely controlled to achieve displaying.

However, due to a size effect caused by the micro-LED chip having a micrometer-level size, a light output efficiency of the LED display device may be affected. Furthermore, due to the size of the micro-LED chip is reduced, a side wall may emit a large amount of light. Therefore, a light output angle of the LED display device may not be sufficiently collimated.

### SUMMARY

The present disclosure provides a LED display device, which may emit collimated light, collimation of output light may be improved.

In an aspect, the present disclosure provides a LED display device, including: a display substrate. The display substrate includes:

an epitaxial layer, including a first semiconductor layer, an active layer, and a second semiconductor layer that are laminated sequentially, where a side of the second semiconductor layer away from the active layer defines a plurality of first recessed regions; a plurality of protruding tabs that are spaced apart from each other are formed based on the plurality of first recessed regions and are arranged on the side of the second semiconductor layer away from the active layer; a depth of each of the plurality of first recessed regions is less than or equal to a thickness of the second semiconductor layer;

a common electrode layer, filling the plurality of first recessed regions and contacting a side wall of each of the plurality of protruding tabs, where the common electrode layer exposes a top wall of each of the plurality of protruding tabs;

a reflective layer, covering the top wall of each of the plurality of protruding tabs and the common electrode layer; and a plurality of reflective electrode patterns, being spaced apart from each other and arranged on a side of the first semiconductor layer away from the active layer, where each of the plurality of reflective electrode patterns is arranged corresponding one of the plurality of protruding tabs; a reflectivity of the reflective layer is less than a reflectivity of the reflective electrode patterns, and a plurality of resonance cavities are formed to enable light to be output from one side of the reflective layer.

In the present disclosure, a plurality of protruding tabs and a plurality of first recessed regions may be arranged in an epitaxial layer, and a common electrode layer may be received in the plurality of first recessed regions. In this way, the common electrode layer may space the plurality of protruding tabs apart from each other. A reflective layer may be arranged at a side of the protruding tabs, and a plurality of reflective electrode patterns may be formed at the opposite side of the protruding tabs. A reflectivity of the reflective layer is less than that of the reflective electrode patterns. In this way, a plurality of resonance cavities may be formed, allowing light to be emitted from one side of the reflective layer, such that collimated light output of the LED display device may be achieved, and collimation of the output light may be improved.

### BRIEF DESCRIPTION OF THE DRAWINGS

FIG. 1 is a structural schematic view of a LED display device according to an embodiment of the present disclosure.
FIG. 2 is a structural schematic view of components of the LED display device according to an embodiment of the present disclosure.
FIG. 3 is a schematic view of a light output effect of a LED display device without a resonance cavity according to an embodiment of the present disclosure.

FIG. 4 is a schematic view of a light output effect of a LED display device arranged with a resonance cavity according to an embodiment of the present disclosure.

FIG. 5 is a flow chart of a method of manufacturing a LED display device according to an embodiment of the present disclosure.

FIG. 6 is a schematic view of a manufacturing process corresponding to the method of manufacturing the LED display device shown in FIG. 5.

FIG. 7 is a schematic view of another manufacturing process corresponding to the method of manufacturing the LED display device shown in FIG. 5.

FIG. 8 is a flow chart of a method of preparing the resonance cavity in the LED display device according to an embodiment of the present disclosure.

FIG. 9 is a schematic view of a preparing process corresponding to the method of preparing the resonance cavity in the LED display device shown in FIG. 8.

FIG. 10 is a flow chart of a method of preparing a wavelength conversion layer and a color filter layer according to an embodiment of the present disclosure.

FIG. 11 is a schematic view of a preparing process corresponding to the method of preparing the wavelength conversion layer and the color filter layer shown in FIG. 10.

FIG. 12 is a flow chart of a method of preparing the color filter layer according to an embodiment of the present disclosure.

FIG. 13 is a schematic view of a preparing process corresponding to the method of preparing the color filter layer shown in FIG. 12.

FIG. 14 is a structural schematic view of a partial structure of the LED display device according to another embodiment of the present disclosure.

FIG. 15 is a flow chart of a method of preparing the color filter layer according to another embodiment of the present disclosure.

FIG. 16 is a schematic view of a preparing process corresponding to the method of preparing the color filter layer of the another embodiment shown in FIG. 15.

FIG. 17 is a structural schematic view of a LED display device according to another embodiment of the present disclosure.

## DETAILED DESCRIPTIONS

The technical solutions in the embodiments of the present disclosure will be described clearly and completely in the following by referring to the accompanying drawings in the embodiments of the present disclosure. Obviously, the described embodiments are only a part of, not all of, the embodiments of the present disclosure. All other embodiments, which are obtained by any ordinary skilled person in the art based on the embodiments in the present disclosure without making creative work, shall fall within the scope of the present disclosure.

The inventor has found, after long-term research, that a light output efficiency of Micro-LED chips is affected due to a size effect generated after the Micro-LED chip is miniaturized to have a micrometer-scaled size; and due to the reduced size of the Micro-LED chips, light emission from a side wall is improved, such that a light output angle of the Micro-LED chips may not be sufficiently collimated. Therefore, the present disclosure provides following embodiments.

The following embodiments of a LED display device of the present disclosure describe exemplary structures of the LED display device.

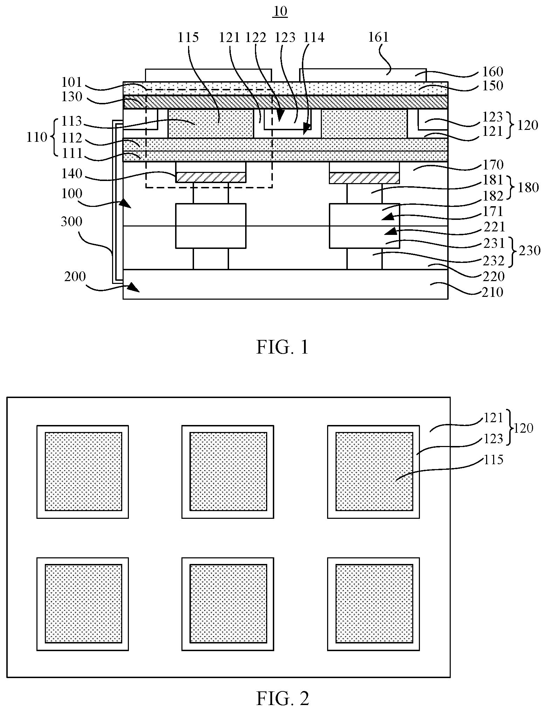

As shown in FIG. 1, the LED display device 10 may include a display substrate 100, a driver substrate 200, and a common wire 300. The display substrate 100 may be configured to form a pixel structure of the LED display device 10. The driver substrate 200 may be configured to form a driver structure of the LED display device 10. The common wire 300 may be configured to electrically connect the display substrate 100 to the driver substrate 200.

The display substrate 100 may include an epitaxial layer 110, a common electrode layer 120, a reflective layer 130, and a plurality of reflective electrode patterns 140.

The epitaxial layer 110 may be configured to emit light by compounding electrons and holes and may define a plurality of display pixels (will be described below). The common electrode layer 120 may serve as an N electrode of the LED display device 10 to supply power to the epitaxial layer 110 and serve as a common electrode to supply power to all of the above-described plurality of display pixels. The common wire 300 may be electrically connected to the common electrode layer 120 and the driver substrate 200. The reflective layer 130 may be disposed on a top of the epitaxial layer 110 and the common electrode layer 120 and may be configured to partially enable light emitted from the epitaxial layer 110 to pass through and partially reflect light emitted from the epitaxial layer 110. The plurality of reflective electrode patterns 140 may be spaced apart from each other and arranged on a side of the epitaxial layer 110 away from the reflective layer 130. The plurality of reflective electrode patterns 140 may be configured to reflect the emitted light from the epitaxial layer 110 and may serve as the P electrode of the LED display device 10 to supply power to the epitaxial layer 110 and serve as pixel electrodes to supply power to the plurality of display pixels described above, respectively.

The common electrode layer 120, the reflective layer 130, and the plurality of reflective electrode patterns 140 may all reflect the light emitted from the epitaxial layer 110. A reflectivity of the reflective layer 130 may be less than a reflectivity of the plurality of reflective electrode patterns 140, such that a plurality of resonant cavities 101 may be formed, where light is output from one side of the reflective layer 130.

Specifically, as shown in FIG. 1, the epitaxial layer 110 may include a first semiconductor layer 111, an active layer 112, and a second semiconductor layer 113 that are laminated sequentially. The first semiconductor layer 111 may be a P-type semiconductor layer, and the second semiconductor layer 113 may be an N-type semiconductor layer. Each of the first semiconductor layer 111 and the second semiconductor layer 113 may be formed by AlN, AlGaN, GaN, InGaN, AlInGaN, GaAs, GaP, GaInN, GaAsP, AlGaAs, AlGaInP, and other semiconductor materials being doped. The active layer 112 is an operating medium layer. The active layer 112 may be, such as, a multi-quantum well structure.

Further, a side of the second semiconductor layer 113 away the active layer 112 may have a plurality of first recessed regions 114. A plurality of protruding tabs 115 that are spaced apart from each other may be defined by the plurality of first recessed regions 114 at the side of the second semiconductor layer 113 away from the active layer 112. A portion of the first semiconductor layer 111 and a portion of the active layer 112 located under the plurality of protruding tabs 115 may serve as the plurality of display pixels of the LED display device 10. When the first semiconductor layer 111 and the second semiconductor layer 113 are connected to an operating voltage, holes from the P-type semiconductor layer and electrons from the N-type semiconductor layer may be compounded in the active layer 112 to emit light.

A depth of each of the plurality of first recessed regions 114 may be less than or equal to a thickness of the second semiconductor layer 113. That is, the depth of the first recessed region 114 does not enable the first recessed region 114 to reach the active layer 112. In this way, non-light-emission compounding, due to damage to the active layer 112, may be avoided, and the light output efficiency of the LED display device 10 may be improved.

In some embodiments, in order to avoid electrical crosstalk between the plurality of display pixels, in an embodiment, an insulating zone (not shown in the drawing), formed by ion bombardment, may be arranged within a portion of the first semiconductor layer 111 and a portion of the active layer 112 corresponding to a bottom of each first recessed region 114. In this way, the portion of the first semiconductor layer 111 and the portion of the active layer 112 below the plurality of protruding tabs 115 may be electrically isolated from each other. The plurality of display pixels may receive different currents from the corresponding reflective electrode patterns 140, and a current of one display pixel may be diffused through the first semiconductor layer 111 and the active layer 112 to another display pixel.

In another embodiment, the thickness and a resistivity of the first semiconductor layer 111 may firstly be set. In this way, when the LED display device 10 is operating normally, a transverse current diffusion length of the first semiconductor layer 111 may satisfy Ls ≤ 1/2*D1, where the Ls is the transverse current diffusion length of the first semiconductor layer 111, and the D1 is a shortest spacing between edges of adjacent two reflective electrode patterns 140 of the plurality of reflective electrode patterns 140.

By setting the thickness and the resistivity of the first semiconductor layer 111, when transverse current diffusion is occurring in the portion of the first semiconductor layer 111 corresponding to one of the plurality of reflective electrode patterns 140, transverse current diffusion in another portion of the first semiconductor layer 111 corresponding to an adjacent one of the plurality of reflective electrode patterns 140 may not be affected. That is, an operating current of each display pixel corresponding to one reflective electrode pattern 140 does not spread to the adjacent display pixel. The portion of the active layer 112 corresponding to each reflective electrode pattern 140 may be independently controlled to emit light. In this way, self-isolation of each display pixel may be achieved by adjusting the transverse current diffusion length on a large-size LED chip, such that reliability and a product yield of the LED display device 10 may be improved, and a probability of electrical leakage may be reduced. Moreover, the self-isolation may simplify a manufacturing process of the chip, and manufacturing costs may be reduced.

As shown in FIG. 1, the common electrode layer 120 may be filled in the plurality of first recessed regions 114 and may contact a side wall of each of the plurality of protruding tabs 115. Furthermore, the common electrode layer 120 may expose a top wall of each of the plurality of protruding tabs 115.

In an embodiment, as shown in FIG. 2, the common electrode layer 120 may surround the plurality of protruding tabs 115 and may fully enclose and contact the side wall of each protruding tab 115. In this way, light in the epitaxial layer 110 may not be transmitted through the side wall of one protruding tab 115 to another protruding tab 115, and light crosstalk may be avoided. In addition, the common electrode layer 120 is interconnected at a spacing region between the plurality of protruding tabs 115 to serve as the common electrode for the plurality of display pixels. When the LED display device 10 is provided with the operating voltage, proper current diffusion may be achieved, such that the epitaxial layer 110 may be provided with a current, enabling the epitaxial layer 110 to emit light based on compounding.

Further, the common electrode layer 120 may include: a first metal electrode layer 121 and a second metal electrode layer 123. The first metal electrode layer 121 may be attached to the side wall of each protruding tab 115 and a bottom of each first recessed region 114 and may be extending following a shape of the side wall and the bottom. The second metal electrode layer 123 may be filled in each second recessed region 122 formed by the first metal electrode layer 121. A reflectivity of the first metal electrode layer 121 may be greater than a reflectivity of the second metal electrode layer 123.

The first metal electrode layer 121 may be configured to conduct the current to the protruding tab 115 and reflect light, which is reflected to the side wall of the protruding tab 115 from an interior of the protruding tab 115. In this way, the light output efficiency of the LED display device 10 may be improved, no crosstalk of light between the plurality of protruding tabs 115. The second metal electrode layer 123 may be configured to supply power to the second semiconductor in the protruding tab 115 by conducting the current to the first metal electrode layer 121, such that the second metal electrode layer 123 and the second semiconductor layer 113 may cooperatively form a common electrode.

Since the reflectivity of the first metal electrode layer 121 may be greater than the reflectivity of the second metal electrode layer 123, the light generated from the protruding tab 115, when reaching the side wall of the protruding tab 115 and the first metal electrode layer 121, may be maximally reflected back into the protruding tab 115. In this way, a loss of light propagating within the first metal electrode layer 121 may be reduced, the light output efficiency of the LED display device 10 may be improved, and costs may be reduced.

In an embodiment, the first metal electrode layer 121 may be an aluminum electrode layer. The aluminum having a high reflectivity may be used as a material of the first metal electrode layer 121, such that the common electrode layer 120 may have a better light reflection effect. The second metal electrode layer 123 may be a copper metal layer, and the copper may have an ideal conductivity, such that a current diffusion efficiency may be improved. Of course, in other embodiments, the first metal electrode layer 121 may alternatively be a metal layer formed by a titanium layer, a chromium layer, an aluminum layer, and other metal layers being doped with each other. The second metal electrode layer 123 may be made of other conductive materials. Materials of the first metal electrode layer 121 and the second metal electrode layer 123 may not be limited herein.

In some embodiments, a side of the common electrode layer 120 away from the active layer 112 may be flush with top walls of the plurality of protruding tabs 115, so as to cooperatively form one continuous plane. The reflective layer 130 may cover the top walls of the plurality of protruding tabs 115 and the common electrode layer 120 to enable the reflective layer 130 to reflect light emitted from the top walls of the plurality of protruding tabs 115. A process of enabling the reflective layer 130 to completely cover the continuous plane formed by the top walls of the plurality of protruding tabs 115 and the common electrode layer 120 may be simpler. The reflective layer 130 may be an aluminum layer or a DBR reflector or may be made of other materials having the ability to reflect light.

The plurality of reflective electrode patterns 140 may be spaced apart from each other and may be arranged on the side of the first semiconductor layer 111 away from the active layer 112. Each of the plurality of reflective electrode patterns 140 may be corresponding to one of the plurality of protruding tabs 115. The reflectivity of the reflective layer 130 may be less than the reflectivity of the reflective electrode patterns 140. In this way, light within each protruding tab 115, when reaching the corresponding reflective electrode pattern 140 and the first metal electrode layer 121 at the side wall of the protruding tab 115, may be reflected back to the interior of the protruding tab 115. In this way, the resonant cavities 101 may be formed, where the light is output from one side of the reflective layer 130, and collimation of the output light of the LED display device 10 may be improved.

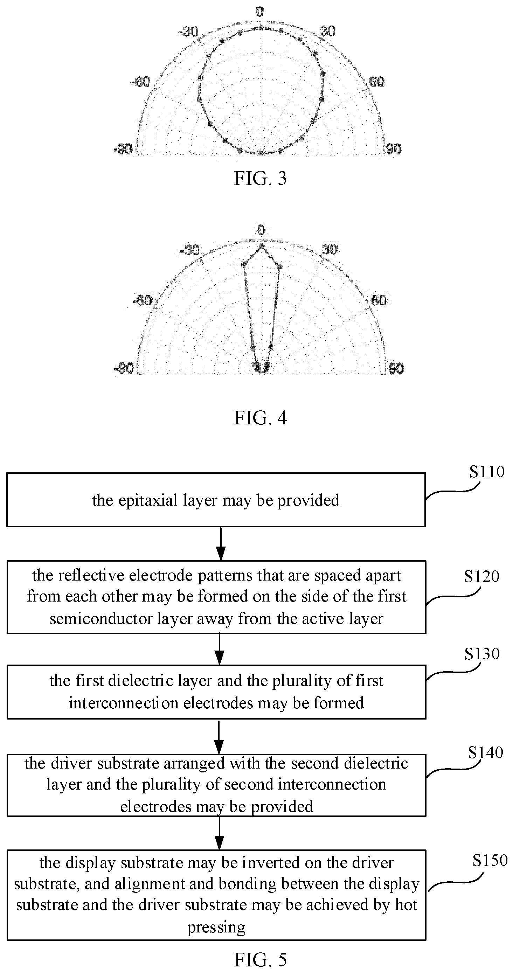

As shown in FIGS. 3 to 4, FIG. 3 is a schematic view of a light output effect of a LED display device without a resonance cavity according to an embodiment of the present disclosure; and FIG. 4 is a schematic view of a light output effect of the LED display device arranged with the resonance cavity according to an embodiment of the present disclosure. By comparing FIG. 3 with FIG. 4, the LED display device 10 without the resonance cavity 101 has a Lambertian type of light output effect where light output angles are scattered. For the LED display device 10 having the resonance cavity 101, the Lambertian type of light output effect is changed, and the light is output along a vertical axis, light output angles of the light may be concentrated, such that collimation of the output light may be improved, and collimated light output may be achieved.

As shown in FIG. 1, the display substrate 100 may further include: a wavelength conversion layer 150 disposed on the side of the reflective layer 130 away from the epitaxial layer 110; and a color filter layer 160 disposed on a side of the wavelength conversion layer 150 away from the epitaxial layer 110. The wavelength conversion layer 150 may be configured to convert first light output from the top walls of the plurality of protruding tabs 115 into second light. The color filter layer 160 may include a plurality of color filter patterns 161 arranged in correspondence with the plurality of protruding tabs 115. Each of the plurality of color filter patterns 161 may be configured to filter the second light into third light. The third light formed by at least a portion of the plurality of color filter patterns 161 may be in different colors.

In some embodiments, the wavelength conversion layer 150 may be arranged on and cover the entire side of the reflective layer 130 away from the epitaxial layer 110. The plurality of color filter patterns 161 may be formed on the side of the wavelength conversion layer 150 away from the epitaxial layer 110 by a developing process, such that the color filter layer 160 may be formed.

For the developing process, a layer of semiconductor coating may be arranged for coverage to form a color photoresist layer. Specified positions of the color photoresist layer may be exposed. A developing solution may be applied to remove the rest portions of the color resist layer. In this way, patterning of the plurality of color filtering patterns 161 at the specified positions may be achieved, and baking and curing may be performed to form the color filter layer 160.

The wavelength conversion layer 150 may be made of a quantum dot material having a certain color. In this way, the first light output from the top wall of each protruding tab 115 may be superimposed, when passing through the wavelength conversion layer 150, with a corresponding color in the wavelength conversion layer 150, such that the second light output from the wavelength conversion layer 150 may be mixed with a color of the wavelength conversion layer 150 to form a mixed color. In some embodiments, the wavelength conversion layer 150 may be formed by a plurality of wavelength conversion sub-layers in different colors being laminated with each other. In this way, the second light having a mixed color of a plurality of colors may be output. The wavelength conversion layer 150 may alternatively be a single layer formed by mixing quantum dot materials in a plurality of colors.

The plurality of color filter patterns 161 may be a plurality of light filters in certain colors, arranged at positions corresponding to the plurality of protruding tabs 115, and the light emitted from the plurality of protruding tabs 115 may be emitted through the plurality of color filter patterns 161.

A color of one color filter pattern 161 may be one of the mixed colors of the second light. When the second light having the mixed color of the plurality of colors passes through each of the plurality of color filter patterns 161, a portion of the second light in one of the plurality of colors corresponding to the corresponding color filter pattern 161 may pass through the corresponding color filter pattern 161, the rest portion of the second light may be filtered out by the color filter pattern 161. In this way, the second light in the mixed color of the plurality of colors may be converted into the third light only in the color of the color filter pattern 161. At least a portion of the plurality of color filter patterns 161 have different colors from the other portion of the plurality of color filter patterns 161. In this way, the third light passing through the plurality of color filter patterns 161 may have different colors, and the plurality of display pixels of the LED display device 10 may display different colors.

For example, when the LED display device 10 needs to mix red light, green light, and blue light with each other, and when the first light emitted by the plurality of protruding tabs 115 is blue light, the wavelength conversion layer 150 may be a green wavelength conversion sub-layer laminated with a red wavelength conversion sub-layer or may be one single layer doped with green quantum dots and red quantum dots. In this way, the wavelength conversion layer 150 may convert the first light, which is blue light, into the second light mixed with a blue color, a green color and a red color. The color filter layer 160 may include the plurality of color filter patterns 161 including a plurality of blue color filter patterns, a plurality of green color filter patterns, and a plurality of red color filter patterns. When the second light passes through the plurality of color filter patterns 161 in three colors, the plurality of blue color filter patterns may filter the second light into the third light in blue, the plurality of green color filter patterns may filter the second light into the third light in green, and the plurality of red color filter patterns may filter the second light into the third light in red. In this way, the LED display device 10 may display light in the three colors, namely the blue light, the green light, and the red light.

As shown in FIG. 1, the display substrate 100 may further include a first dielectric layer 170 and a plurality of first interconnection electrodes 180. The first dielectric layer 170 may cover a side of the first semiconductor layer 111 away from the active layer 112 and the plurality of reflective electrode patterns 140. The first dielectric layer 170 may define a plurality of first via holes 171 to expose the plurality of reflective electrode patterns 140. The plurality of first interconnection electrodes 180 may be respectively received in the plurality of first via holes 171 and may be respectively conductively connected to the plurality of reflective electrode patterns 140.

The first dielectric layer 170 may be an oxide layer made of silicon dioxide or other insulating materials and may be configured to fix a position of the plurality of first interconnection electrodes 180 and may serve as a mask and protective layer for blocking diffusion of impurities. The first interconnection electrode 180 may be an electrode made of metallic copper or other materials having electrical conductivity.

As shown in FIG. 1, the drive substrate 200 may include a power supply substrate 210, a second dielectric layer 220, and a plurality of second interconnection electrodes 230. The second dielectric layer 220 may define a plurality of second via holes 221. The plurality of second interconnection electrodes 230 may be respectively received in the plurality of second via holes 221. The second dielectric layer 220 and the plurality of second interconnection electrodes 230 are arranged on the power supply substrate 210 and form a Damascene structure on the power supply substrate 210. The first transfer electrode 180 may be electrically connected to the power supply substrate 210 to enable the power supply substrate 210 to transfer a current to the second interconnection electrode 230.

The second dielectric layer 220 may be an oxide layer made of silicon dioxide or other insulating materials and may be configured to fix positions of the plurality of second interconnection electrodes 230 and may serve as a mask and protective layer to prevent diffusion of impurities. The plurality of second interconnection electrodes 230 may be an electrode made of metallic copper or other materials having electrical conductivity.

In some embodiments, the first dielectric layer 170 and the second dielectric layer 220 may be aligned to and bonded with each other by hot pressing; and the plurality of first interconnection electrodes 180 and the plurality of second interconnection electrodes 230 may be respectively aligned to and bonded with each other by hot pressing. In this way, the plurality of first interconnection electrodes 180 and the plurality of second interconnection electrodes 230 may be connected and integrated with each other; and the first dielectric layer 170 and the second dielectric layer 220 may be connected and integrated with each other, so as to form one integral structure, such that high strength connection between the display substrate 100 and the driver substrate 200 may be achieved. In this way, the power supply substrate 210 may transfer the current, through the plurality of first interconnection electrodes 180 and the plurality of second interconnection electrodes 230, to the first semiconductor layer 111 in the epitaxial layer 110.

In some embodiments, each of the plurality of first interconnection electrodes 180 may include a first electrode portion 181 disposed near the reflective electrode pattern 140 and a second electrode portion 182 disposed away from the reflective electrode pattern 140. Each of the plurality of second interconnection electrodes 230 may include a third electrode portion 231 disposed near the first interconnection electrode 180 and a fourth electrode portion 232 disposed away from the first interconnection electrode 180. In a direction perpendicular to a lamination direction of the first semiconductor layer 111, the active layer 112, and the second semiconductor layer 113, a size of the first electrode portion 181 may be smaller than a size of the second electrode portion 182, and a size of the fourth electrode portion 232 may be smaller than a size of the third electrode portion 231. In this way, a contact area between contact surfaces of the first interconnection electrode 180 and the second interconnection electrode 230 may be increased, such that fusion between the first interconnection electrode 180 and the second interconnection electrode 230 may be improved, and strength of the connection therebetween may further improved.

In an embodiment, a plurality of switching components (not shown in the drawings) may be arranged in an array on the power supply substrate 210. Each of the plurality of second interconnection electrodes 230 may be electrically connected to a respective one of the plurality of switching components. That is, the plurality of switching components and the plurality of reflective electrode patterns 140 may be in one-to-one correspondence with each other, such that drive signals may be provided from the plurality of connected switching components to the plurality of second interconnection electrodes 230. The drive signals may pass through the plurality of second interconnection electrodes 230, the plurality of first interconnection electrodes 180, and the plurality of reflective electrode patterns 140 sequentially to reach the first semiconductor layer 111 in the epitaxial layer 110. In this way, each of the plurality of display pixels may be individually controlled.

As shown in FIG. 1, the LED display device 10 may further include the common wire 300, which may be arranged at an exterior of the display substrate 100 and the driver substrate 200 and may electrically connect the common electrode layer 120 to the driver substrate 200. In an implementation, the common electrode layer 120 may be exposed from a side of the display substrate 100. One end of the common traveler 300 may be fixedly connected to the second metal electrode layer 123 in the common electrode layer 120, and the other end of the common electrode layer 120 may be connected to the driver substrate 200. The common wire 300 may be fixedly connected to the common electrode layer 120 and the driver substrate 200 by means of wire bonding, enabling the current provided by the driver substrate 200 to be transmitted, through the common wire 300, to the common electrode layer 120.

In other embodiments, a hole may be formed at a position of a non-display-pixel region of the display substrate 100 corresponding to the driver substrate 200. The common wire 300 may extend through the hole to be connected to the common electrode layer 120 and the driver substrate 200.

Taking the above structure of the LED display device 10 as an example, in the following, a method of manufacturing the LED display device 10 will be described.

In an embodiment, partial components of the display substrate 100 may be firstly fixed to the driver substrate 200, and the partial components of the display substrate 100 may be processed to form the plurality of resonant cavities 101.

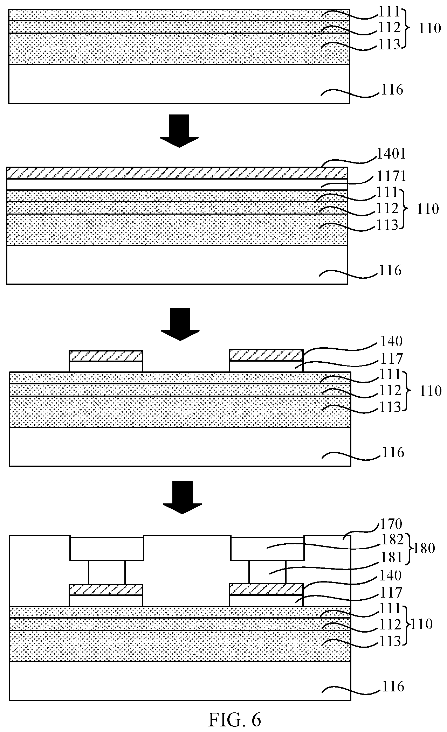

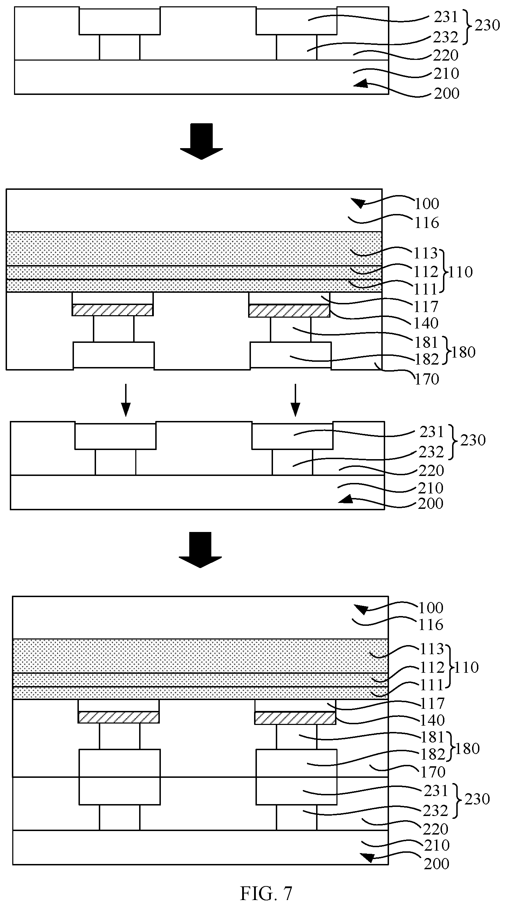

Specifically, operations of preparing the partial components of the display substrate 100 and the driver substrate 200 and connecting the partial components of the display substrate 100 to the driver substrate 200 may be shown in FIGS. 5 to 7. FIG. 5 shows a process of preparing the partial components of the display substrate 100 and a process of bonding the partial components to the driver substrate 200; FIG. 6 is a schematic view of a preparation process corresponding to operations S110-S130 shown in FIG. 5; and FIG. 7 is a schematic view of a preparation process corresponding to operations S140-S150 shown in FIG. 5. In other embodiments, the following preparation operations may be adjusted.

In an operation S110, the epitaxial layer may be provided.

The epitaxial layer 110 may be growing on the substrate 116 to be formed thereon. Alternatively, the epitaxial layer 110 may be transferred to be fixed on the substrate 116. For example, the epitaxial layer 110 may be fixed on the substrate 116 by taking the second semiconductor layer 113 to face towards the substrate 116. The substrate 116 may be coated with an adhesive before contacting the epitaxial layer 110, such that the substrate 116 may be bonded and fixed to the epitaxial layer 110.

In an operation S120, the reflective electrode patterns that are spaced apart from each other may be formed on the side of the first semiconductor layer away from the active layer.

In an implementation, a transparent electrode layer 1171, such as a transparent electrode ITO, may be arranged, by annealing, to cover a surface of the first semiconductor layer 111 of the epitaxial layer 110. After the annealing is completed, the transparent electrode layer 1171 may be in ohmic contact with the epitaxial layer 110. After the annealing, a metal electrode layer 1401 may be arranged on and cover a surface of the transparent electrode layer 1171. The transparent electrode layer 1171 and the metal electrode layer 1401 may be etched to obtain a plurality of transparent electrodes 117 and the plurality of reflective electrode patterns 140. A spacing between every two of the plurality of reflective electrode patterns 140 may be calculated in accordance with a distance demanded for the plurality of display pixels of the LED display device 10.

In some embodiments, after the plurality of reflective electrode patterns 140 that are spaced apart from each other are formed, the spacing region between every adjacent two of the plurality of reflective electrode patterns 140 may be ion bombarded, such that the portion of the epitaxial layer 110 corresponding to the spacing region between every adjacent two of the plurality of reflective electrode patterns 140 may form an insulating region. In this way, portions of the epitaxial layer 110 corresponding to the plurality of reflective electrode patterns 140 may be electrically isolated from each other, and the plurality of display pixels may be independent from each other.

Alternatively, a method of controlling transverse current diffusion may be applied. The thickness and the resistivity of the first semiconductor layer 111 may be set in advance. In this way, when the LED display device 10 is operating normally, the transverse current diffusion length of the first semiconductor layer 111 may satisfy $Ls \leq 1/2 * D1$, where the Ls is the transverse current diffusion length of the first semiconductor layer 111, and the D1 is a shortest spacing between edges of the adjacent two reflective electrode patterns 140.

Alternatively, a portion of the first semiconductor layer 111 corresponding to the spacing region between every adjacent two of the plurality of reflective electrode patterns 140 may be etched firstly, and an etching depth may not exceed the thickness of the first semiconductor layer 111. The spacing region between every adjacent two of the plurality of reflective electrode patterns 140 may be ion bombarded, or the diffusion current of the first semiconductor layer 111 may be controlled, so as to form the insulating zone.

By arranging the insulating zone or applying the method of controlling the transverse current diffusion on a side of the plurality of reflective electrode patterns 140, the plurality of display pixels may be isolated from each other without damaging the active layer 112, such that reliability and the product yield of the LED display device 10 may be improved, and a probability of electrical leakage may be reduced.

In an operation S130, the first dielectric layer and the plurality of first interconnection electrodes may be formed.

In an embodiment, the first electrode portions 181 may be placed facing towards the reflective electrode patterns 140, and the plurality of first interconnection electrodes 180 may be correspondingly placed at a side of the plurality of reflective electrode patterns 140 away from the epitaxial layer 110. In this way, the plurality of reflective electrode patterns 140 that are spaced apart from each other and the plurality of first interconnection electrodes 180 may be formed on the side of the epitaxial layer 110 away from the substrate 116.

In some embodiments, the first dielectric layer 170 may be filled between the plurality of reflective electrode patterns 140 and the plurality of first interconnection electrodes 180. A side of first dielectric layer 170 away from the epitaxial layer 110 exceeds top ends of a plurality of second electrode portions 182 of the plurality of first interconnection electrodes 180 away from the epitaxial layer 110. A chemical-mechanical polishing (CMP) process may be performed to enable a portion of the first dielectric layer 170 exceeding the plurality of second electrode portions 182 to be less than 3 nm, such that the Damascene structure may be formed. Furthermore, the side of each first interconnection electrode 180 away from the epitaxial layer 110 may be slightly concave with respect to a surface of the first dielectric layer 170, but at the same time, surfaces of the first interconnection electrodes 180 and the first dielectric layer 170 maintain flat at a nanometer level, such that preparation may be made for subsequent connection with the driver substrate 200.

In another embodiment, the first dielectric layer 170 may be formed firstly. The plurality of first via holes 171 may be formed by performing an exposure and developing process and an etching process for twice. Furthermore, magnetron sputtering, electroplating, or other processes may be performed within the plurality of first via holes 171 to form the plurality of first interconnection electrodes 180.

In an operation S140, the driver substrate arranged with the second dielectric layer and the plurality of second interconnection electrodes may be provided.

A process of forming the second dielectric layer 220 and the plurality of second interconnection electrodes 230 may be similar to that of forming the first dielectric layer 170 and the plurality of first interconnection electrodes 180, and will not be repeated herein.

The second dielectric layer 220, arranged on a side of the power supply substrate 210, may exceed top ends of the plurality of second interconnection electrodes 230 away from the power supply substrate 210. A chemical mechanical polishing (CMP) process may be performed to enable a portion of the second dielectric layer 220 exceeding the plurality of second interconnection electrodes 230 to be less than 3 nm. In this way, a surface of each second interconnection electrode 230 away from the power supply substrate 210 may be slightly concaved with respect to the surface of the second dielectric layer 220, but at the same time, surfaces of the second interconnection electrodes 230 and the second dielectric layer 220 maintain flat at a nanometer level.

In an operation S150, the display substrate may be inverted on the driver substrate, and alignment and bonding between the display substrate and the driver substrate may be achieved by hot pressing.

After surfaces of the display substrate 100 and the driver substrate 200 are plasma activated or chemically treated, the display substrate 100 may be invertedly placed on the driver substrate 200 by enabling the second electrode portion 182 of each first interconnection electrode 180 to face towards the third electrode portion 231 of each respective second interconnection electrode 230. A bonding device may be used to enable the first interconnection electrode 180 and the second interconnection electrode 230 to be accurately aligned to each other. By using the bonding device, accuracy of alignment of the first interconnection electrode 180 and the second interconnection electrode 230 may be improved, and deviation may be reduced.

At this moment, the second interconnection electrode 230 may be arranged in correspondence with the first interconnection electrode 180, the transparent electrode layer, and the reflective electrode pattern 140, and the first dielectric layer 170 may be attached to the second dielectric layer 220. However, the second interconnection electrode 230 and the first interconnection electrode 180 may be slightly recessed from a plane on which the first dielectric layer 170 is attached to the second dielectric layer 220. Therefore, the second electrode portion 182 of the second interconnection electrode 230 is not attached to the third electrode portion 231 of the first interconnection electrode 180.

After aligning, the first dielectric layer 170 and the second dielectric layer 220 may be aligned to and bonded to each other; and the first interconnection electrode 180 and the second interconnection electrode 230 may be aligned to and bonded to each other. Specifically, the two substrates may be heated and pressurized, such that the first dielectric layer 170, the second dielectric layer 220, the first interconnection electrode 180, and the second interconnection electrode 230 are thermally expanded.

Since a thermal expansion coefficient of the metal is greater than that of the dielectric material, an expansion volume of the first interconnection electrode 180 and an expansion volume of the second interconnection electrode 230 may be greater than that of the first dielectric layer 170 and that of the second dielectric layer 220. When the first dielectric layer 170 and the second dielectric layer 220 diffuse to and fuse with each other, the second electrode portion 182 and the third electrode portion 231 may be expanded to connect to each other at an interface in which the first dielectric layer 170 and the second dielectric layer 220 contact each other, and the second electrode portion 182 and the third electrode portion 231 may diffuse into each other to form an integral structure. In this way, the first dielectric layer 170 and the second dielectric layer 220 may be aligned and bonded with each other; and the first interconnection electrode 180 and the second interconnection electrode 230 may be aligned and bonded with each other. In this way, high strength connection between the display substrate 100 and the driver substrate 200 may be achieved.

At this moment, the driver substrate 200 may supply power to the first semiconductor layer 111 of the epitaxial layer 110 through the plurality of first interconnection electrodes 180, the plurality of second interconnection electrodes 230, and the plurality of reflective electrode patterns 140. The driver substrate 200, the plurality of second interconnection electrodes 230 and the plurality of reflective electrode patterns 140 may serve as the P electrode of the LED display device 10.

After achieving the high strength connection between the display substrate 100 and the driver substrate 200, the display substrate 100 may further be processed to form the plurality of resonant cavities 101.

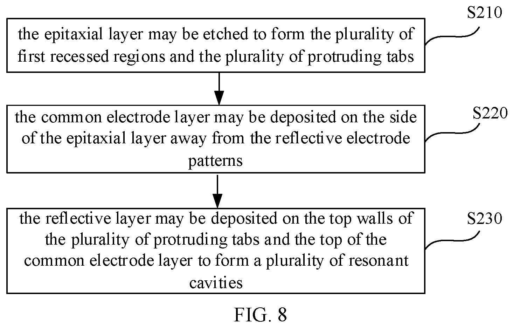

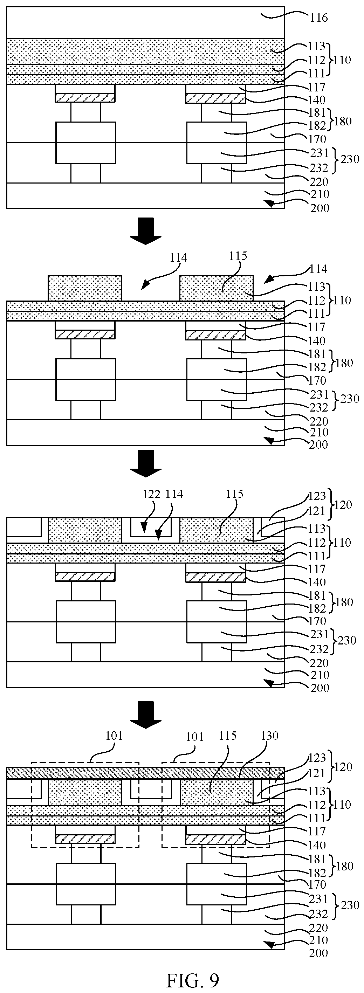

A preparation process of the resonant cavities 101 of the LED display device 10 may be shown in FIGS. 8 to 9. FIG. 8 shows a method of preparing the resonant cavities in the LED display device of the present disclosure, and FIG. 9 is a schematic view of the preparation process corresponding to the operations shown in FIG. 8.

In an operation S210, the epitaxial layer may be etched to form the plurality of first recessed regions and the plurality of protruding tabs.

The substrate 116 may be removed by processes such as grinding, chemical etching, or laser lift-off (LLO), enabling the epitaxial layer 110 to be exposed. Subsequently, a plurality of positions on a side of the epitaxial layer 110 away from the plurality of reflective electrode patterns 140 may be etched. A depth of the etching may be less than or equal to the thickness of the second semiconductor layer 113, such that the plurality of first recessed regions 114 may be formed in the surface of the epitaxial layer 110. The plurality of protruding tabs 115 that are spaced apart from each other may be formed in the second semiconductor layer 113 by the plurality of first recessed regions 114. The plurality of protruding tabs 115 may be in one-to-one correspondence with the plurality of reflective electrode patterns 140, such that the plurality of display pixels of the LED display device 10 may be formed. The plurality of reflective electrode patterns 140 may reflect light emitted from the plurality of protruding tabs 115. The driver substrate 200 may supply the current to the epitaxial layer 110 through the plurality of reflective electrode patterns 140, such that the plurality of display pixels of the LED display device 10 may be individually controlled.

In an embodiment, after forming the plurality of protruding tabs 115, the side of the epitaxial layer 110 away from the plurality of reflective electrode patterns 140 may be ion bombarded to form an insulating zone. In this way, portions of the first semiconductor layer 111 and portions of the active layer 112 under the plurality of protruding tabs 115 may be electrically isolated from each other within the epitaxial layer 110. Alternatively, the method of controlling the transverse current diffusion may be applied. The thickness and the resistivity of the first semiconductor layer 111 may be set in advance. When the LED display device 10 is operating normally, the transverse current diffusion length of the first semiconductor layer 111 may satisfy $Ls \leq 1/2 * D1$, where the Ls is the transverse current diffusion length of the first semiconductor layer 111, and the D1 is a shortest spacing between edges of adjacent two reflective electrode patterns 140 of the plurality of reflective electrode patterns 140. By performing the method of controlling the transverse current diffusion or arranging the insulating zone, the plurality of display pixels may be isolated from each other, such that reliability and the product yield of the LED display device 10 may be improved, and the probability of electrical leakage may be reduced.

The transverse current diffusion length Ls of the first semiconductor layer 111 may be calculated based on the following formula:

$$L\_s=\sqrt{(kT/e \times t/(\rho J\_0))} \tag{1}$$

The k may be the Boltzmann constant, the T may be a thermodynamic temperature, the e may be an electron charge, the t may be the thickness of the first semiconductor layer 111, the $\rho$ may be the resistivity of the first semiconductor layer 111, and the J_0 may be a current density within a first current diffusion layer covered by the reflective electrode patterns 140 when the LED display device 10 is operating normally. Therefore, the transverse current diffusion length Ls may decrease as the thickness t of the first semiconductor layer 111 decreases and may decrease as the resistivity $\rho$ of the first semiconductor layer 111 increases. Therefore, the transverse current diffusion length Ls may be reduced to enable the operating current of one display pixel corresponding to one reflective electrode pattern 140 to not diffuse to the adjacent display pixel, such that self-isolation of each display pixel may be achieved.

In an operation S220, the common electrode layer may be deposited on the side of the epitaxial layer away from the reflective electrode patterns.

Further, the first metal electrode layer 121 may be deposited on the side of the epitaxial layer 110 away from the reflective electrode patterns 140, enabling the first metal electrode layer 121 to cover the top walls of the plurality of protruding tabs 115 and the plurality of first recessed regions 114, such that the first metal electrode layer 121 may completely cover tops and the side walls of all of the plurality of protruding tabs 115, and the first metal electrode layer 121 may reflect any light leaked out of the side wall of any protruding tab 115.

After the first metal electrode layer 121 is deposited and covers the epitaxial layer 110, the plurality of second recessed regions 122 may be formed on the side of the first metal electrode layer 121 away from the epitaxial layer 110, and the plurality of second metal electrode layers 123 may be filled in each of the plurality of second recessed regions 122 of the first metal electrode layer 121 by electroplating, such that the second metal electrode layers 123 may fill any gap between the plurality of protruding tabs 115. Tops of the plurality of second metal electrode layers 123 away from the epitaxial layer 110 may exceed the tops of the plurality of protruding tabs 115 away from the reflective electrode patterns 140. Further, a chemical mechanical polishing (CMP) process may be performed on sides of the plurality of second metal electrode layers 123 away from the epitaxial layer 110, such that the plurality of protruding tabs 115 may be exposed to expose the first semiconductor layer 111 of the epitaxial layer 110. By performing the CMP process, any excess metal electrode layer may be removed, the thickness of the first semiconductor layer 111 may be precisely controlled, such that a required thickness of each resonant cavity may be achieved.

The plurality of second metal electrode layers 123 and the first metal electrode layer 121 may cooperatively form the common electrode layer 120. The plurality of second metal electrode layers 123 located between the plurality of protruding tabs 115 may be connected to each other. In this way, the common electrode layer 120 may serve as the common electrode of the LED display device 10, and proper current diffusion may be achieved.

A portion of some of the plurality of second metal electrode layers 123 away from the side wall of the protruding tab 115 may be exposed. Wire bonding may be performed at the exposed portion at edges of the second metal electrode layers 123 to enable the second metal electrode layers 123 to be connected to a substrate of the driver substrate 200 via the common wire 300, such that the common electrode layer 120 of the display substrate 100 may be electrically connected to the driver substrate 200. In other embodiments, the common electrode layer 120 of the display substrate 100 may be electrically connected to the driver substrate 200 via TSV hole connection.

In an operation S230, the reflective layer may be deposited on the top walls of the plurality of protruding tabs and the top of the common electrode layer to form a plurality of resonant cavities.

The reflective layer 130 may be deposited on the tops of the plurality of protruding tabs 115 away from the reflective electrode patterns 140 and on the top of the second metal electrode, such that the reflective layer 130 may cover the top walls of the plurality of protruding tabs 115 and the common electrode layer 120. At this moment, the plurality of protruding tabs 115 may be wrapped by the first metal electrode, the reflective layer 130, and the reflective electrode patterns 140 to form the plurality of resonance cavities 101. The reflectivity of the reflective layer 130 may be less than that of the reflective electrode patterns 140, such that light, after entering the plurality of resonant cavities 101, may be concentrated to be output from one side of the reflective layer 130. In other embodiments, a microlens layer may be arranged on the side of the reflective layer 130 away from the plurality of protruding tabs 115 to enable the light output angle to be more collimated.

After completing preparation of the plurality of resonant cavities 101, the wavelength conversion layer 150 and the color filter layer 160 of the LED display device 10 may further be prepared to form the colored plurality of display pixels.

In following embodiments, preparing the wavelength conversion layer 150 and the color filter layer 160 will be described based on examples where red display pixels, green display pixels, blue display pixels may be prepared, and the light emitted from the plurality of protruding tabs 115 may be the blue light.

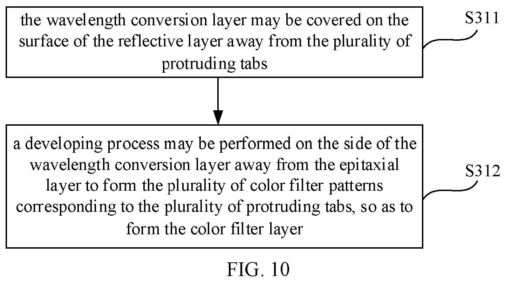

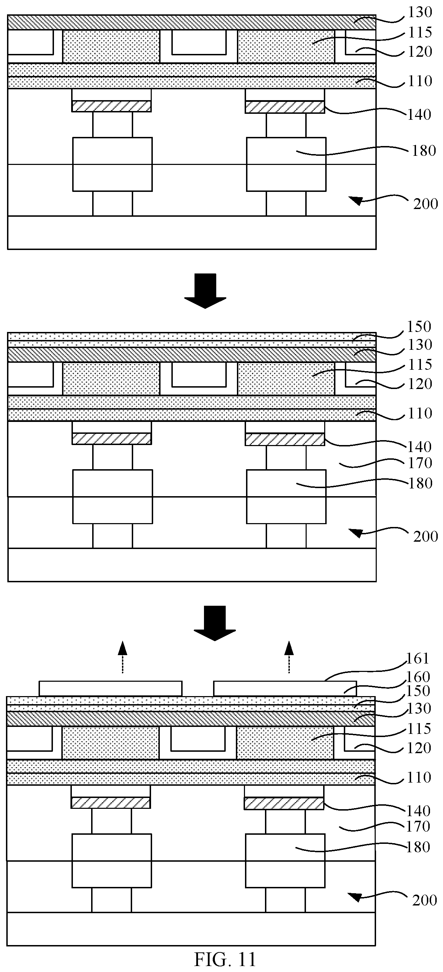

Specifically, the process of preparing the wavelength conversion layer 150 and the color filter layer 160 of the LED display device 10 may be achieved in various embodiments. In an embodiment shown in FIGS. 10 and 11, FIG. 10 is a flow chart of preparing the wavelength conversion layer 150 and the color filter layer 160 in an embodiment of the present disclosure; and FIG. 11 is a schematic view of the preparation process corresponding to the operations shown in FIG. 10.

In an operation S311, the wavelength conversion layer may be covered on the surface of the reflective layer away from the plurality of protruding tabs.

The wavelength conversion layer 150 may be formed by laminating a plurality of wavelength conversion sub-layers in a plurality of colors. For example, a green wavelength conversion sub-layer may be firstly deposited to cover the surface of the reflective layer 130 away from the plurality of protruding tabs 115. A thickness and a surface flatness of the green wavelength conversion sub-layer may be precisely controlled by thermal evaporation plating, a homogenization process, or the CMP process. In this way, the entire wavelength conversion sub-layer may have uniformity in wavelength conversion and in light intensity. In this case, the blue first light emitted from the plurality of protruding tabs 115 may form light in a blue-green mixed color after passing through the green wavelength conversion sub-layer.

A red wavelength conversion sub-layer may be deposited in a similar manner on a surface of the green wavelength conversion sub-layer 150. A thickness and surface flatness of the red wavelength conversion sub-layer may be precisely controlled by the thermal evaporation plating, the homogenization process, or the CMP process. At this moment, the two wavelength conversion sub-layers may cooperatively form the wavelength conversion layer 150, the light in the blue-green mixed color emitted from the green wavelength conversion sub-layer may, after passing through the red wavelength conversion sub-layer, form the second light in a blue-green-red mixed color.

Alternatively, the wavelength conversion layer 150 may be a film made of the green quantum dot material or the red quantum dot material. During manufacturing the LED display device 10, the wavelength conversion layer 150 may be attached and fixed to the surface of the reflective layer 130 away from the plurality of protruding tabs 115 by an optical glue, such that difficulty of manufacturing and processing the LED display device 10 may be reduced.

An effect of mixing three colors may be adjusted by controlling the material and the thickness of the wavelength conversion layer 150. In other embodiments, the wavelength conversion layer 150 may alternatively be a single layer made of a mixture of the green quantum dot material and the red quantum dot material, such that a green-red mixed color may be achieved. Of course, in other implementations, according to demands for the light emitted from the LED display device 10, wavelength conversion sub-layers in different colors may be additionally arranged or the color of the wavelength conversion layer 150 may be changed to adjust a color mixing effect of the second light.

In an operation S312, a developing process may be performed on the side of the wavelength conversion layer away from the epitaxial layer to form the plurality of color filter patterns corresponding to the plurality of protruding tabs, so as to form the color filter layer.

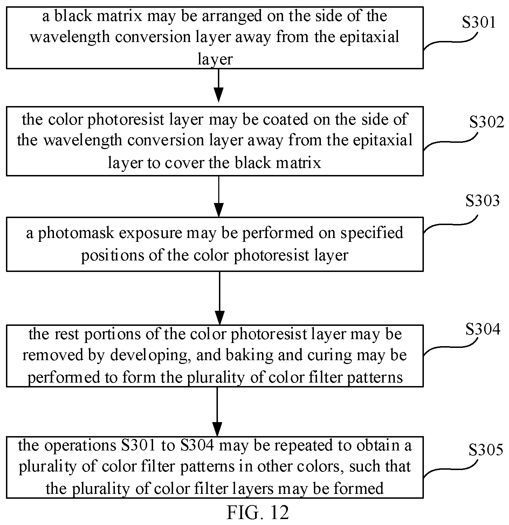

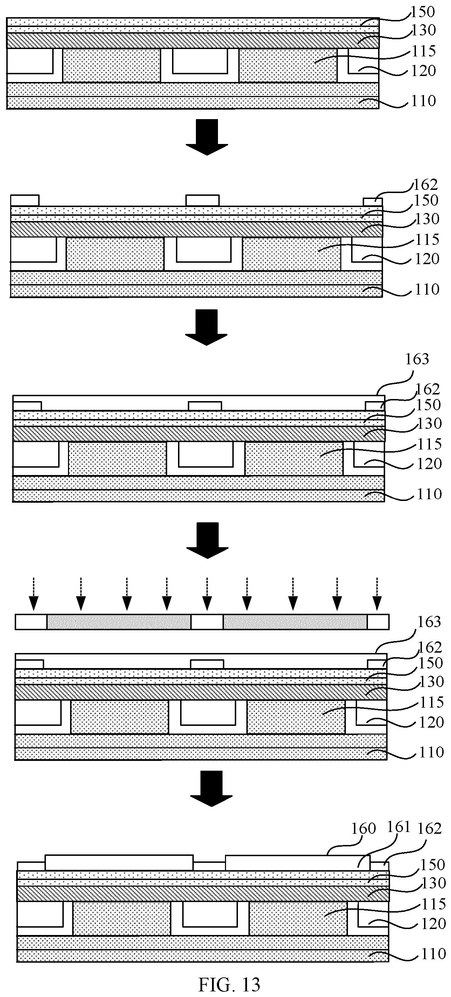

The operation S312 of preparing the color filter layer 160 may include operations S301-S305. Specifically, as shown in FIGS. 12 and 13, FIG. 12 is a flow chart of preparing the color filter layer 160 in an embodiment of the present disclosure; and FIG. 13 is a schematic view of preparation processes corresponding to the operations shown in FIG. 12.

In an operation S301, a black matrix may be arranged on the side of the wavelength conversion layer away from the epitaxial layer.

Specifically, a black matrix 162, such as chromium having a low reflectivity or black resin, may be arranged on the side of the wavelength conversion layer 150 away from the epitaxial layer 110. The black matrix 162 may expose a plurality of positions corresponding to the plurality of protruding tabs 115 on the side of the wavelength conversion layer 150 away from the epitaxial layer 110, such that the black matrix may be formed.

In an operation S302, the color photoresist layer may be coated on the side of the wavelength conversion layer away from the epitaxial layer to cover the black matrix.

The color photoresist layer 163 may be coated on the side of the wavelength conversion layer 150 away from the epitaxial layer 110. The color photoresist layer 163 may fill gaps of the black matrix and may cover the black matrix. The color photoresist layer 163 may be in a color of one of blue, green, and red.

In an operation S303, a photomask exposure may be performed on specified positions of the color photoresist layer.

Further, the photomask exposure may be performed on the specified positions of the color photoresist layer 163, such that the color photoresist layer 163 may be fixed at the specified positions.

In an operation S304, the rest portions of the color photoresist layer may be removed by developing, and baking and curing may be performed to form the plurality of color filter patterns.

Unnecessary portions of the color photoresist layer 163 may be removed by a developing solution, such that portions of the color photoresist layer 163 at the specified positions may be left. The portions of the color photoresist layer 163 at the specified positions may be cured by baking, so as to form the plurality of color filter patterns 161. The specified positions may be positions corresponding to a portion of the plurality of protruding tabs 115, such that the LED display device 10 may emit light in a specific color after the light passes through the plurality of color filter patterns 161.

In an operation S305, the operations S301 to S304 may be repeated to obtain a plurality of color filter patterns in other colors, such that the plurality of color filter layers may be formed.

The above operations may be repeated twice, the plurality of color filter patterns 161 in the other two colors may be cured respectively. In this way, the color filter layer 160 may be formed, the second light in the blue-green-red mixed color emitted from the wavelength conversion layer 150 may be filtered to obtain the third light in one color, and the three colors of blue, green, and red may be separated from each other. In this way, the plurality of display pixels of the LED display device 10 may emit light in different colors.

In the present disclosure, the wavelength conversion layer 150 may be completely covered, and the plurality of color filter patterns 161 may be prepared on the wavelength conversion layer 150 by first covering and then removing, such that the plurality of color display pixels may be obtained, and the plurality of color filter patterns 161 may not need to be sprayed at specified positions. In this way, the color filter layer 160 and the wavelength conversion layer 150 may be more uniform and flat, and the thickness of the wavelength conversion layer 150 and the thickness of the color filter layer 160 may be better controlled. Furthermore, a process of preparing the plurality of color display pixels may be simplified, the product yield may be improved, enabling mass production of the LED display device 10 described in the present disclosure.

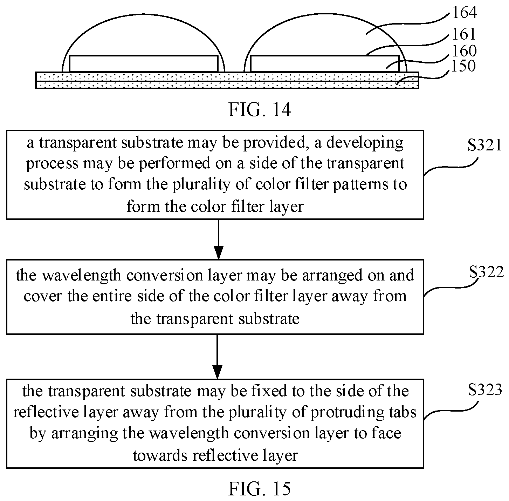

After the LED display device 10 is manufactured, other processing operations may be additionally performed as desired. For example, as shown in FIG. 14, the microlenses 164 may be additionally arranged on the plurality of color filter patterns 161, such that an array of the microlenses may be formed in the color filter layer 160, such that an output pattern of the output light may further be regulated.

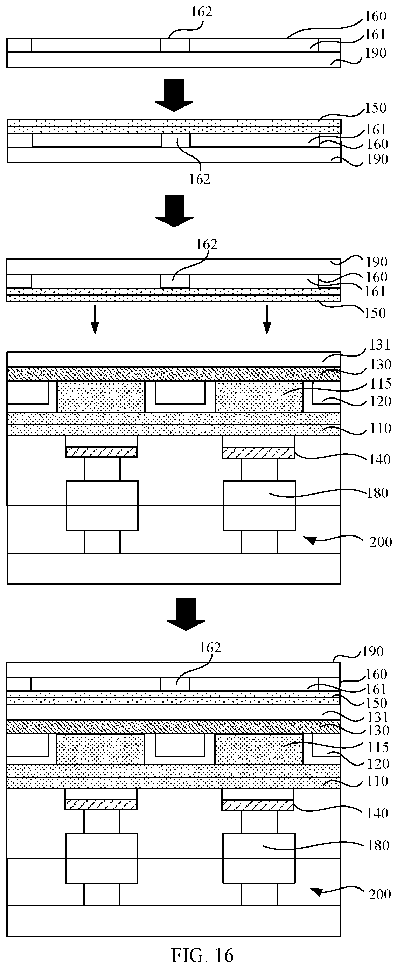

In addition, the wavelength conversion layer 150 and the color filter layer 160 may be prepared in another embodiment. As shown in FIG. 15 and FIG. 16, FIG. 15 is a flow chart of preparing the wavelength conversion layer 150 and the color filter layer 160 of the present disclosure in another embodiment; and FIG. 16 is a schematic view of the preparation process corresponding to the operations shown in FIG. 15.

In an operation S321, a transparent substrate may be provided, a developing process may be performed on a side of the transparent substrate to form the plurality of color filter patterns to form the color filter layer.

The transparent substrate 190 may be provided, and the transparent substrate 190 may be a colorless transparent substrate 190 such as a non-conductive glass substrate or an acrylic substrate. In this way, light may pass through the transparent substrate 190, and the transparent substrate 190 may not affect a color of the light.

According to the configuration of the plurality of protruding tabs 115 of the LED display device 10, the specific positions on the transparent substrate 190 where the plurality of color filter patterns 161 may be arranged and areas of the specific positions may be determined in advance, so as to prepare the plurality of color filter patterns 161 corresponding to the plurality of protruding tabs 115. Operations of preparing the color filter layer 160 on the side of the transparent substrate 190 may be referred to the operations S301-S305, which will not be repeated herein. Sides of the plurality of color filter patterns 161 away from the transparent substrate 190 may be flush with the side of the black substrate 162 away from the transparent substrate 190, such that a flat surface may be formed, facilitating subsequent operations to be performed.

In an operation S322, the wavelength conversion layer may be arranged on and cover the entire side of the color filter layer away from the transparent substrate.

The process of preparing the wavelength conversion layer 150 on the side of the color filter layer 160 away from the transparent substrate 190 may be similar to the process of preparing the wavelength conversion layer 150 on the surface of the reflective layer 130 as described in the operation S311, and therefore, the operation S311 may be referred and will not be repeated herein.

In an operation S323, the transparent substrate may be fixed to the side of the reflective layer away from the plurality of protruding tabs by arranging the wavelength conversion layer to face towards reflective layer.

In some embodiments, the wavelength conversion layer 150 on the transparent substrate 190 may be fixed to the side of the reflective layer 130 away from the plurality of protruding tabs 115 by arranging an optical adhesion layer 131. The optical adhesion layer 131 may be an optical adhesive, which is colorless and transparent, has a light transmittance rate of 90% or more, has ideal bonding strength, and has small curing shrinkage. For example, the optical adhesive may be organic silicone, polyurethane, epoxy resin, and the like. In this way, stability of the LED display device 10 may be improved, and an influence of the optical adhesion layer 131 on the first light emitted from the reflective layer 130 may be reduced.

In some embodiments, a layer of the optical adhesion layer 131 may be applied to the side of the reflective layer 130 away from the plurality of protruding tabs 115. Subsequently, the transparent substrate 190 may be inverted, the wavelength conversion layer 150 may face towards the optical adhesion layer 131 to be attached to the optical adhesion layer 131. During attaching, the plurality of color filter patterns 161 on the transparent substrate 190 may be arranged to be in one-to-one correspondence with the plurality of protruding tabs 115. The optical adhesion layer 131 may further be cured, such that positions of the wavelength conversion layer 150 and the plurality of color filter patterns 161 may be fixed, such that aligned assembling and fixation between the transparent substrate 190 and the color filter layer 160 may be completed.

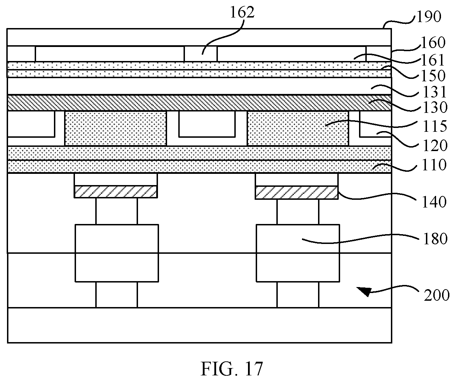

The LED display device 10 obtained in the present embodiment is shown in FIG. 17. The display substrate 100 may further include the optical adhesion layer 131 disposed on the side of the reflective layer 130 away from the epitaxial layer 110. A side of the optical adhesion layer 131 away from the reflective layer 130 may be attached and fixed to the wavelength conversion layer 150. The plurality of color filter patterns 161 may be disposed on the side of the wavelength conversion layer 150 away from the optical adhesion layer 131. The plurality of color filter patterns 161 may be spaced apart from each other by the black substrate 162. The side of color filter layer 160 away from the wavelength conversion layer 150 may be fixedly arranged with the transparent substrate 190.

In this way, the first light emitted from the plurality of protruding tabs 115 may pass through the optical adhesion layer 131 and then pass through the wavelength conversion layer 150, to form the second light in the blue-green-red mixed color. The plurality of color filter patterns 161 may filter the second light to obtain the third light in different colors The third light may further pass through the transparent substrate 190 to be emitted to an outside.

In this way, the transparent substrate 190 may isolate and protect the plurality of color filter patterns 161, preparation processes of the wavelength conversion layer 150 and the color filter layer 160 may be performed more easily. While the wavelength conversion layer 150 and the color filter layer 160 are prepared, other components of the LED display device 10 may be prepared at the same time. A time duration of the manufacturing the LED display device 10 may be reduced.

In summary, in the present disclosure, the plurality of protruding tabs 115 and the plurality of first recessed regions 114 may be arranged in the epitaxial layer 110. The reflective layer 130 may be arranged on a side of the plurality of protruding tabs 115, and the plurality of reflective electrode patterns 140 may be arranged on the opposite side of the plurality of protruding tabs 115. The reflectivity of the reflective layer 130 may be smaller than the reflectivity of the reflective electrode patterns 140. In this way, the plurality of resonant cavities 101 may be formed, where light is emitted from one side of the reflective layer 130, such that the LED display device 10 may output light collimatedly, collimation of the output light may be improved. Moreover, the display substrate 100 and the driver substrate 200 may be aligned and bonded to each other by hot pressing, such that high strength connection may be achieved. Meanwhile, the plurality of color display pixels of the LED display device 10 may be prepared by firstly arranging the wavelength conversion layer 150 for coverage and then arranging the color filter layer 160. In this way, processes of preparing the color display pixels may be the simple, and the product yield may be improved.

The above descries embodiments of the present disclosure, and does not limit the scope of the present disclosure. Any equivalent structure or equivalent process transformation performed based on the contents of the specification and the accompanying drawings, applied directly or indirectly in other related technical fields, shall be included in the scope of the present disclosure.

## Claims

1. A LED display device, comprising: a display substrate, wherein the display substrate comprises:

   an epitaxial layer, comprising a first semiconductor layer, an active layer, and a second semiconductor layer that are laminated sequentially, wherein a side of the second semiconductor layer away from the active layer defines a plurality of first recessed regions; a plurality of protruding tabs that are spaced apart from each other are formed based on the plurality of first recessed regions and are arranged on the side of the second semiconductor layer away from the active layer; a depth of each of the plurality of first recessed regions is less than or equal to a thickness of the second semiconductor layer;
   a common electrode layer, filling the plurality of first recessed regions and contacting a side wall of each of the plurality of protruding tabs, wherein the common electrode layer exposes a top wall of each of the plurality of protruding tabs;
   a reflective layer, covering the top wall of each of the plurality of protruding tabs and the common electrode layer; and
   a plurality of reflective electrode patterns, being spaced apart from each other and arranged on a side of the first semiconductor layer away from the active layer, wherein each of the plurality of reflective electrode patterns is arranged corresponding one of the plurality of protruding tabs; a reflectivity of the reflective layer is less than a reflectivity of the reflective electrode patterns, and a plurality of resonance cavities are formed to enable light to be output from one side of the reflective layer.

2. The LED display device according to claim 1, wherein the common electrode layer surrounds the plurality of protruding tabs and fully encloses and contacts the side wall of each of the plurality of protruding tabs.

3. The LED display device according to claim 1, wherein the common electrode layer comprises:

a first metal electrode layer, attached to the side wall of each of the plurality of protruding tabs and a bottom of each of the plurality of first recessed regions, and extending following a shape of the side wall and the bottom; and a second metal electrode layer, filling a plurality of second recessed regions formed by the first metal electrode layer, wherein a reflectivity of the first metal electrode layer is greater than a reflectivity of the second metal electrode layer.

4. The LED display device according to claim 1, wherein an insulating zone is formed by ion bombardment within a portion of the first semiconductor layer and a portion of the active layer corresponding to the bottom of each of the plurality of first recessed regions;
another portion of the first semiconductor layer and another portion of the active layer located below one of the plurality of protruding tabs are electrically isolated, within the epitaxial layer, from still another portion of the first semiconductor layer and still another portion of the active layer located below another one of the plurality of protruding tabs; or a thickness and a resistivity of the first semiconductor layer are set to enable a transverse current diffusion length of the first semiconductor layer to satisfy $Ls \leq 1/2*D1$ during the LED display device operating normally, wherein the Ls is the transverse current diffusion length of the first semiconductor layer, and the D1 is a shortest spacing between edges of adjacent reflective electrode patterns of the plurality of reflective electrode patterns.

5. The LED display device according to claim 1, wherein a side of the common electrode layer away from the active layer is flush with top walls of the plurality of protruding tabs; and the side of the common electrode layer away from the active layer and the top walls of the plurality of protruding tabs cooperatively form one continuous plane.

6. The LED display device according to claim 1, wherein the display substrate further comprises: a wavelength conversion layer disposed on a side of the reflective layer away from the epitaxial layer; and a color filter layer disposed on a side of the wavelength conversion layer away from the epitaxial layer; wherein the wavelength conversion layer is configured to convert a first light output from top walls of the plurality of protruding tabs into second light; the color filter layer comprises a plurality of color filter patterns arranged in correspondence with the plurality of protruding tabs; the plurality of color filter patterns is configured to filter the second light into third light; at least a portion of the plurality of color filter patterns emit light in colors different from each other.

7. The LED display device according to claim 6, wherein, the wavelength conversion layer covers an entire surface of the reflective layer away from the epitaxial layer, the plurality of color filter patterns are formed by a developing process on the side of the wavelength conversion layer away from the epitaxial layer.

8. The LED display device according to claim 6, further comprising: a transparent substrate disposed on the side of the reflective layer away from the epitaxial layer, wherein the wavelength conversion layer is disposed on and covers an entire side of the transparent substrate away from the reflective layer; the plurality of color light filter patterns are formed, by a developing process, on a side of the wavelength conversion layer away from the transparent substrate.

9. The LED display device according to claim 1, wherein, the display substrate further comprises a first dielectric layer and a plurality of first interconnection electrodes; the first dielectric layer covers the side of first semiconductor layer away from the active layer and the plurality of reflective electrode patterns; the first dielectric layer defines a plurality of first via holes allowing the plurality of reflective electrode patterns to be exposed; the plurality of first interconnection electrodes are respectively received in the plurality of first via holes and are respectively conductively connected to the plurality of reflective electrode patterns; the LED display device further comprises a driver substrate, the driver substrate comprises a second dielectric layer and a plurality of second interconnection electrodes; the second dielectric layer defines a plurality of second via holes, the plurality of second interconnection electrodes are respectively received in the plurality of second via holes; the first dielectric layer is aligned and bonded to the second dielectric layer by hot pressing; the plurality of first interconnection electrodes are respectively aligned and bonded to the plurality of second interconnection electrodes by hot pressing.

10. The LED display device according to claim 9, wherein each of the plurality of first interconnection electrodes comprises: a first electrode portion disposed near a respective one of the plurality of reflective electrode patterns; and a second electrode portion disposed away from the respective reflective electrode pattern;

each of the plurality of second interconnection electrodes comprises: a third electrode portion disposed near a respective one of the plurality of first interconnection electrodes; and a fourth electrode portion disposed away from the respective first interconnection electrode;

in a direction perpendicular to a laminating direction of the first semiconductor layer, the active layer, and the second semiconductor layer, a size of the first electrode portion is smaller than a size of the second electrode portion of the first electrode portion, and a size of the fourth electrode portion is smaller than a size of the third electrode portion.

11. The LED display device according to claim 9, further comprising a common wire, which electrically connecting the common electrode layer to the driver substrate at an outer side of the display substrate and the driver substrate.

FIG. 1

FIG. 2

FIG. 3

FIG. 4

| | |
|---|---|
| the epitaxial layer may be provided | S110 |

↓

| | |
|---|---|
| the reflective electrode patterns that are spaced apart from each other may be formed on the side of the first semiconductor layer away from the active layer | S120 |

↓

| | |
|---|---|
| the first dielectric layer and the plurality of first interconnection electrodes may be formed | S130 |

↓

| | |
|---|---|
| the driver substrate arranged with the second dielectric layer and the plurality of second interconnection electrodes may be provided | S140 |

↓

| | |
|---|---|
| the display substrate may be inverted on the driver substrate, and alignment and bonding between the display substrate and the driver substrate may be achieved by hot pressing | S150 |

FIG. 5

FIG. 6

FIG. 7

| the epitaxial layer may be etched to form the plurality of first recessed regions and the plurality of protruding tabs | S210 |

| the common electrode layer may be deposited on the side of the epitaxial layer away from the reflective electrode patterns | S220 |

| the reflective layer may be deposited on the top walls of the plurality of protruding tabs and the top of the common electrode layer to form a plurality of resonant cavities | S230 |

FIG. 8

FIG. 9

| the wavelength conversion layer may be covered on the surface of the reflective layer away from the plurality of protruding tabs | S311 |

↓

| a developing process may be performed on the side of the wavelength conversion layer away from the epitaxial layer to form the plurality of color filter patterns corresponding to the plurality of protruding tabs, so as to form the color filter layer | S312 |

FIG. 10

FIG. 11

a black matrix may be arranged on the side of the wavelength conversion layer away from the epitaxial layer — S301

the color photoresist layer may be coated on the side of the wavelength conversion layer away from the epitaxial layer to cover the black matrix — S302

a photomask exposure may be performed on specified positions of the color photoresist layer — S303

the rest portions of the color photoresist layer may be removed by developing, and baking and curing may be performed to form the plurality of color filter patterns — S304

the operations S301 to S304 may be repeated to obtain a plurality of color filter patterns in other colors, such that the plurality of color filter layers may be formed — S305

FIG. 12

FIG. 13

164
161
160
150

FIG. 14

| a transparent substrate may be provided, a developing process may be performed on a side of the transparent substrate to form the plurality of color filter patterns to form the color filter layer | S321 |

| the wavelength conversion layer may be arranged on and cover the entire side of the color filter layer away from the transparent substrate | S322 |

| the transparent substrate may be fixed to the side of the reflective layer away from the plurality of protruding tabs by arranging the wavelength conversion layer to face towards reflective layer | S323 |

FIG. 15

162 160
161
190

150
161
160
190
162

162 190
160
161
150

131
130
115
120
110
140
180
200

162 190
160
161
150
131
130
115
120
110
140
180
200

FIG. 16

FIG. 17

## INTERNATIONAL SEARCH REPORT

| | International application No. |
|---|---|
| | **PCT/CN2023/133010** |

**A. CLASSIFICATION OF SUBJECT MATTER**

H01L33/46(2010.01)i; H10K59/00(2023.01)i

According to International Patent Classification (IPC) or to both national classification and IPC

**B. FIELDS SEARCHED**

Minimum documentation searched (classification system followed by classification symbols)

IPC: H01L,H10K

Documentation searched other than minimum documentation to the extent that such documents are included in the fields searched

Electronic data base consulted during the international search (name of data base and, where practicable, search terms used)

CNTXT, ENTXTC, EXTXT, WPABS, DWPI, CNKI: 显示, 微, 发光二极管, 外延层, 半导体层, 有源层, 凹, 凸, 台, 公共电极, 反射, 图案, 谐振, 准直, display, micro, LED, epitaxial layer, semiconductor layer, active layer, concave, convex, step, common electrode, reflective, pattern, resonance, collimate

**C. DOCUMENTS CONSIDERED TO BE RELEVANT**

| Category* | Citation of document, with indication, where appropriate, of the relevant passages | Relevant to claim No. |
|---|---|---|
| A | US 2019123033 A1 (SPY EYE, LLC.) 25 April 2019 (2019-04-25) description, paragraphs [0006]-[0100], and figures 2-17 | 1-11 |
| A | CN 115148870 A (XIAMEN SILAN ADVANCED COMPOUND SEMICONDUCTOR CO., LTD.) 04 October 2022 (2022-10-04) entire document | 1-11 |
| A | US 2018261785 A1 (INTEL CORP.) 13 September 2018 (2018-09-13) entire document | 1-11 |
| A | CN 109768149 A (SAMSUNG ELECTRONICS CO., LTD.) 17 May 2019 (2019-05-17) entire document | 1-11 |
| A | US 2022262981 A1 (FACEBOOK TECHNOLOGIES, LLC.) 18 August 2022 (2022-08-18) entire document | 1-11 |

☐ Further documents are listed in the continuation of Box C.　　☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **26 December 2023** | **03 January 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

INTERNATIONAL SEARCH REPORT
Information on patent family members

International application No.

**PCT/CN2023/133010**

| Patent document cited in search report | | | Publication date (day/month/year) | Patent family member(s) | | | Publication date (day/month/year) |
|---|---|---|---|---|---|---|---|
| US | 2019123033 | A1 | 25 April 2019 | US | 10388641 | B2 | 20 August 2019 |
| CN | 115148870 | A | 04 October 2022 | None | | | |
| US | 2018261785 | A1 | 13 September 2018 | US | 10186676 | B2 | 22 January 2019 |
| | | | | US | 2019157598 | A1 | 23 May 2019 |
| | | | | US | 10510974 | B2 | 17 December 2019 |
| CN | 109768149 | A | 17 May 2019 | JP | 2019087746 | A | 06 June 2019 |
| | | | | JP | 7359537 | B2 | 11 October 2023 |
| | | | | EP | 3483933 | A1 | 15 May 2019 |
| | | | | EP | 3483933 | B1 | 04 October 2023 |
| | | | | US | 2020381475 | A1 | 03 December 2020 |
| | | | | US | 10964747 | B2 | 30 March 2021 |
| | | | | KR | 20190052887 | A | 17 May 2019 |
| | | | | KR | 102486391 | B1 | 09 January 2023 |
| | | | | US | 2019140016 | A1 | 09 May 2019 |
| | | | | US | 10784309 | B2 | 22 September 2020 |
| US | 2022262981 | A1 | 18 August 2022 | US | 11569414 | B2 | 31 January 2023 |
| | | | | WO | 2022177998 | A1 | 25 August 2022 |
| | | | | TW | 202234721 | A | 01 September 2022 |
| | | | | US | 2023139307 | A1 | 04 May 2023 |

Form PCT/ISA/210 (patent family annex) (July 2022)